# FASCICULE DE BREVET EUROPEEN

(11) **EP 1 455 451 B1**
(45) Date de publication et mention de la délivrance du brevet: **11.11.2009**
(21) Numéro de dépôt: 04290499.5
(22) Date de dépôt: 25.02.2004
(51) Int. Cl.: H03K 5/05

(54) **Dispositif de traitement de signal optique**
Vorrichtung zur optischen Signalverarbeitung
Device for optical signal processing

(30) Priorité: 07.03.2003 FR 0302828
(43) Date de publication de la demande: 08.09.2004
(73) Titulaire: Alcatel Lucent, 75008 Paris (FR)
(72) Inventeur: Godin, Jean, 94100 St-Maur-des-Fosses (FR)
(74) Mandataire: Korakis-Ménager, Sophie

(56) Documents cités:
- US-A- 3 253 165
- US-A- 3 456 128
- US-A- 3 889 134
- MURATA K ET AL: "AN OPTOELECTRONIC CLOCK RECOVERY CIRCUIT USING A RESONANT TUNNELING DIODE AND A UNI-TRAVELING-CARRIER PHOTODIODE" IEICE TRANSACTIONS ON COMMUNICATIONS, COMMUNICATIONS SOCIETY, TOKYO, JP, vol. E82-B, no. 8, 1 août 1999 (1999-08-01), pages 1228-1235, XP001033213 ISSN: 0916-8516
- AKEYOSHI T ET AL: "ApplicationS of Resonant-Tunneling Diodes to High Speed Digital IC's" 1999 11TH. INTERNATIONAL CONFERENCE ON INDIUM PHOSPHIDE AND RELATED MA TERIALS. CONFERENCE PROCEEDINGS. IPRM DAVOS, MAY 16 - 20, 1999; [INTERNATIONAL CONFERENCE ON INDIUM PHOSPHIDE AND RELATED MATERIALS], NEW YORK, NY : IEEE, US, vol. CONF. 11, 16 mai 1999 (1999-05-16), pages 405-410, XP002257719 ISBN: 978-0-7803-5563-7
- KIMIKAZU SANU ET AL: "An 80-Gb/s Optoelectronic Delayed Flip-Flop IC Using Resonant Tunneling Diodes and Uni-Traveling-Carrier Photodiode" IEEE JOURNAL OF SOLID-STATE CIRCUITS, IEEE SERVICE CENTER, PISCATAWAY, NJ, US, vol. 36, no. 2, 1 février 2001 (2001-02-01), pages 281-289, XP002257720 ISSN: 0018-9200

## Description

La présente invention concerne un dispositif de traitement de signal optique. Ce dispositif est particulièrement adapté à la réalisation de circuit de décision dans le domaine de la transmission de signaux optiques à très haut débit.

Il est de plus en plus important de disposer de réseaux de transmission à très haut débit afin de satisfaire les besoins grandissants en service liés aux transmissions de données. La fibre optique, avec sa large bande passante, est le support de prédilection pour les transmissions à longue distance.

Typiquement, un signal optique se présente sous la forme d'une onde porteuse modulée entre des niveaux hauts, ou « 1 » logiques, et bas, ou « 0 » logiques, au rythme d'une fréquence d'horloge qui impose le débit. La durée allouée pour contenir une information binaire, ou temps bit, est donc la période d'horloge.

On peut aujourd'hui réaliser des systèmes de transmission à des débits de 40 Gbit/s utilisant le multiplexage temporel. Une transmission optique à plusieurs Tbit/s est alors possible en combinant une transmission à 40 Gbit/s par longueur d'onde et un multiplexage en longueur d'onde.

Pour atteindre de telles performances, des circuits très rapides sont nécessaires ; ainsi, il est notamment très important de concevoir des circuits de décision fonctionnant à des débits de 40 Gbit/s et même au-delà, jusqu'à 80 Gbit/s. Un circuit de décision optoélectronique permet notamment de convertir avec un certain délai les niveaux successifs d'un signal optique modulé reçu dont il est difficile de dire s'ils correspondent à des « 1 » logiques ou des « 0 » logiques, en un signal électrique numérique plus facile à interpréter.

Le document « An 80-Gb/s optoelectronic delayed flip-flop IC using resonant tunnelling diodes and uni-traveling carrier photodiode » (Kimikazu et al., IEEE Journal of Solid State Circuits, vol. 36, n°2, février 2001) décrit ainsi un circuit de décision permettant de fonctionner à un débit de 80 Gbit/s. Ce circuit de décision comporte deux diodes à effet tunnel résonnant en série et une photodiode unipolaire en parallèle sur l'une des deux diodes à effet tunnel résonnant. C'est la tension aux bornes de la photodiode combinée avec le front d'horloge qui permet de changer d'état stable. Ce circuit permet de recopier avec un certain retard un signal optique modulé d'entrée, le processus de conversion ayant lieu sur le front montant d'un signal d'horloge.

Toutefois, un tel circuit pose certaines difficultés.

Ainsi, la marge de phase, autrement dit l'aptitude à tolérer un décalage temporel entre le signal d'horloge et le rythme d'horloge du signal de données est un critère crucial. Dans le cas du circuit de décision décrit dans le document "An 80-Gb/s optoelectronic delayed flip-flop IC using resonant tunnelling diodes and uni-traveling carrier photodiode", cette marge de phase est nécessairement réduite en fonctionnement à haute fréquence, et donc notamment à des débits de 80 Gbit/s, et il est particulièrement difficile d'obtenir, avec une marge d'erreur faible, un front d'horloge à un instant où un signal de données modulé selon un format de type RZ (« retour à zéro ») est lisible.

La présente invention vise à fournir un dispositif de traitement d'un signal d'entrée ayant un format de type RZ « retour à zéro » permettant d'obtenir une marge de phase améliorée à haute fréquence.

La présente invention propose à cet effet un dispositif de traitement d'un signal optique de données d'entrée ayant un format de modulation de type RZ « retour à zéro », comportant un composant électronique ayant une caractéristique de diode tunnel présentant un courant de pic et un courant de vallée ledit dispositif étant caractérisé en ce qu'il comporte :
- une source de courant commandée apte à injecter dans ledit composant électronique un courant électrique fonction d'un signal de commande, ledit courant pouvant prendre une première valeur de courant ou une deuxième valeur de courant,
- des moyens générateurs de courant aptes à injecter dans ledit composant électronique un courant électrique additionnel généré en réponse audit signal de données d'entrée,
ledit courant de vallée ayant une valeur supérieure strictement à ladite première valeur de courant et ledit courant de pic ayant une valeur comprise entre ladite deuxième valeur de courant et la somme de ladite deuxième valeur de courant et de la valeur dudit courant généré par lesdits moyens générateurs.

Typiquement, le signal de commande a une fonction de réinitialisation et correspond à un train d'impulsions en créneau. Le composant électronique ayant une caractéristique de diode tunnel possède une configuration bistable ayant deux états stables A et B. L'apparition d'une impulsion de commande force le composant dans son état stable A . Mais, entre deux impulsions de commande, si le signal d'entrée RZ présente un niveau haut, le composant passe d'un état stable initial A à l'autre état stable B ; par contre, si le signal d'entrée présente un niveau bas, le composant reste dans son état initial. Grâce à l'invention, il suffit que le signal d'entrée prenne un niveau haut correspondant à un « 1 » logique entre deux impulsions de contrôle pour que le composant passe de l'état A à l'état B. En prenant des durées d'impulsion de commande suffisamment courtes par rapport au temps bit, on peut ainsi améliorer considérablement la marge de phase.

De manière avantageuse, ledit composant électronique est une diode à effet tunnel résonnant.

Selon un premier mode de réalisation, ledit composant électronique est une diode à effet tunnel résonnant photosensible qui constitue lesdits moyens générateurs de courant.

Avantageusement, ladite source de courant comporte deux transistors montés en paire différentielle alimentée par un courant fixé, l'un desdits transistors étant monté en série avec ledit composant électronique.

Selon un deuxième mode de réalisation, ladite source de courant comporte deux transistors montés en paire différentielle alimentée par un courant fixé, l'un desdits transistors étant un transistor photosensible monté en série avec ledit composant électronique, ledit transistor photosensible constituant lesdits moyens générateurs de courant.

Avantageusement, ledit format de modulation du signal de données d'entrée présentant un temps bit donné, ledit signal de commande est formé d'impulsions de tension de durée inférieure au demi temps bit.

La présente invention a également pour objet un circuit de décision pour signal de données d'entrée ayant un format de modulation de type RZ « retour à zéro » présentant un rythme d'horloge de fréquence donnée, caractérisé en ce qu'il comprend un dispositif de traitement selon l'invention, et en ce que ledit signal de commande est constitué d'un train d'impulsions ayant ladite fréquence donnée.

D'autres caractéristiques et avantages de la présente invention apparaîtront dans la description suivante d'un mode de réalisation de l'invention, donnée à titre illustratif et nullement limitatif.

Dans les figures suivantes :
- La figure 1 représente un premier mode de réalisation d'un dispositif de traitement selon l'invention,
- Les figures 2 à 5 représentent des caractéristiques courant-tension du dispositif représenté en figure 1,
- La figure 6 représente des chronogrammes de différents signaux de fonctionnement du dispositif représenté en figure 1,
- La figure 7 représente un deuxième mode de réalisation d'un dispositif de traitement selon l'invention,
- La figure 8 représente un troisième mode de réalisation d'un dispostif de traitement selon l'invention.

Dans toutes les figures, les éléments communs portent les mêmes numéros de référence.

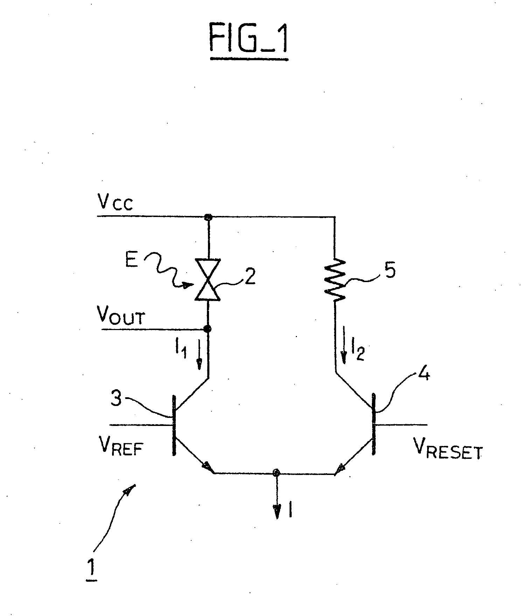

La figure 1 représente un dispositif de traitement 1 selon l'invention.

Le dispositif de traitement 1 comporte :
- une diode à effet tunnel résonnant photosensible 2,
- un premier transistor bipolaire 3,
- un deuxième transistor bipolaire 4,
- une résistance 5.

Le document «Phase-locking of an InP/InGaP/InGaAs resonant tunnelling diode relaxation oscillator by direct optical injection» (Kahn et al., Solid-State Electronics, vol. 45, 2001, pages 1827-1830) décrit une manière de fabriquer la diode à effet tunnel résonnant photosensible 2.

Les transistors bipolaires 3 et 4 sont par exemple des transistors bipolaires à hétérojonction.

La diode à effet tunnel résonnant photosensible 2 est reliée par sa première borne à un potentiel Vcc, habituellement nul, et par sa deuxième borne au collecteur du transistor bipolaire 3.

La résistance 5 est reliée par sa première borne au potentiel Vcc et par sa deuxième borne au collecteur du transistor bipolaire 4.

Les transistors bipolaires 3 et 4 sont montés en paire différentielle et leurs émetteurs sont reliés chacun à une source commune de courant I.

La base du transistor 3 est fixée à un potentiel V_{REF} sensiblement constant.

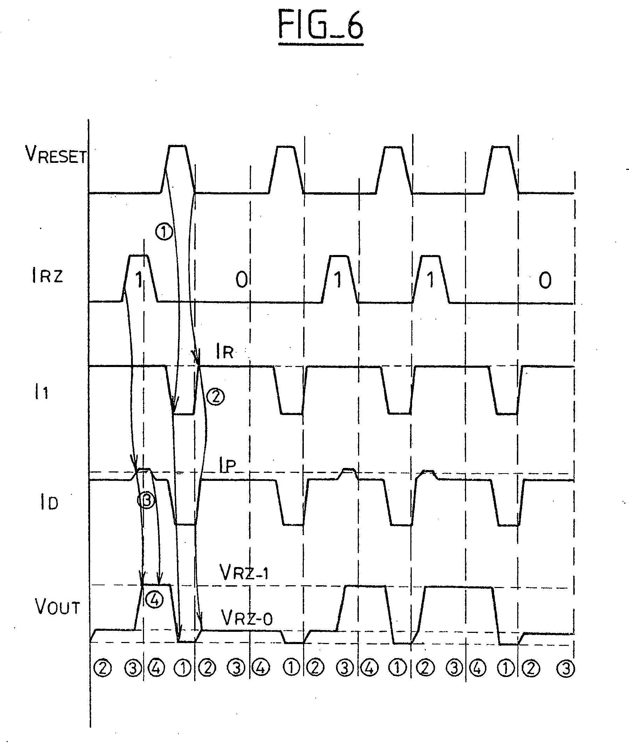

La base du transistor 4 est commandée par un signal V_{RESET}. Ce signal V_{RESET} est un signal impulsionnel, la durée d'impulsion étant inférieure à la durée d'un demi-temps bit. Un tel signal est représenté en fonction du temps en figure 6 et prend une valeur variant par exemple entre 0 et une valeur maximale V_{RESET-MAX}. Dans ce cas, la tension V_{REF} est une tension comprise strictement entre 0 et V_{RESET-MAX}, par exemple égale à V_{RESET-MAX}/2.

Le dispositif 1 peut être réalisé sous la forme d'un circuit intégré. Ainsi, le document «InP-based monolithically integrated RTD/HBT mobile for logic circuits» (Otten et al., Conference Proceedings. 13th IPRM, 14-18 mai 2001, pages 232-235) décrit la manière d'intégrer une diode à effet tunnel résonnant avec un transistor bipolaire à hétérojonction.

La diode 2 reçoit un signal de données optiques E tel qu'un signal optique cadencé à une fréquence bit par exemple de l'ordre de 80 Gbit/s.

La tension de sortie V_{OUT} fournie par le dispositif 1 se retrouve au collecteur du transistor 3.

Nous appellerons de façon générale I₁ le courant circulant dans le transistor 3 et la diode 2 et I₂ le courant circulant dans le transistor 4 et la résistance 5.

Une impulsion V_{RESET} sur la base du transistor 4 entraîne que tout le courant I circule dans la branche de droite comprenant la résistance 5 et le transistor 4. Le courant I₁ est donc très faible tandis que le courant I₂ est sensiblement égale à I. Le courant circulant dans la diode 2 est quasi nul ; la tension aux bornes de la diode 2 est quasi nulle et la tension de sortie V_{OUT} est égale à V_{CC} et est donc sensiblement nulle.

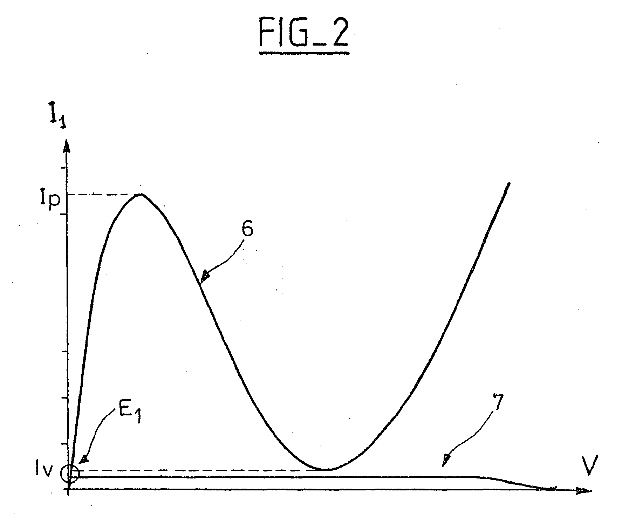

Ce premier état E₁ est illustré sur la figure 2 qui représente les caractéristiques courant-tension I₁-V respectives 6 et 7 de la diode 2 et du transistor 3.

La caractéristique 6 courant-tension de la diode 2 est une caractéristique classique de diode tunnel représentant le courant dans la diode en fonction de la tension à ses bornes ; cette caractéristique présente un courant de pic Iₚ et un courant de vallée I_{V}.

La caractéristique 7 représente la caractéristique du courant de collecteur du transistor 3 en fonction de la tension entre le collecteur et l'émetteur du transistor 3. Cette caractéristique est représentée « à l'envers » avec l'origine à la valeur de la polarisation ; ainsi, au croisement des caractéristiques 6 et 7, on a bien une égalité de courants et une polarisation.

On voit que cet état E₁ correspondant à l'intersection des courbes 6 et 7 présente un courant très faible inférieur au courant de vallée. On a donc bien un courant I₁ très faible et une tension de sortie V_{OUT} quasi nulle.

A la fin de l'impulsion V_{RESET}, le courant I alimente la branche de gauche, et donc le courant I₁ n'est plus nul et prend une valeur I_{R} voisine de I, inférieure au courant pic I_{P}. Le dispositif 1 est alors dans l'état E₂.

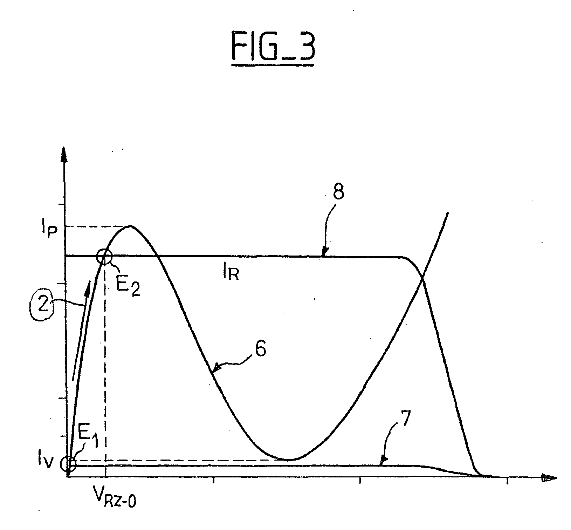

Le passage de l'état E₁ à ce deuxième état E₂ est représenté par la flèche ② sur la figure 3.

La caractéristique 8 représente la caractéristique du courant de collecteur du transistor 3 en fonction de la tension entre le collecteur et l'émetteur du transistor en l'absence de d'impulsion V_{RESET}.

L'état E₂ est alors défini par l'intersection de la caractéristique 8 du transistor 3 et de la caractéristique 6 de la diode 2.

La tension aux bornes de la diode 2 sensiblement égale à la tension V_{OUT} est égale à V_{RZ-0} située avant la tension de pic de la caractéristique 6 correspondant au courant de pic I_{P}.

Le transistor 3 et la diode 2 sont traversés par le courant I_{R} inférieur au courant pic I_{P}.

Cet état E₂ est un état de fonctionnement stable.

Lorsqu'un signal E optique correspondant à une impulsion (donc à un « 1 » logique) de lumière arrive sur la diode 2 avant la prochaine impulsion V_{RESET}, cette impulsion de lumière est convertie par la diode 2 photosensible en une impulsion de courant I_{RZ} qui vient s'ajouter au courant I_{R} traversant la diode 2. Ainsi, si on appelle I_{D} le courant traversant la diode en tenant compte de ce photocourant, ce courant I_{D} vaut à cet instant I_{R} + I_{RZ}.

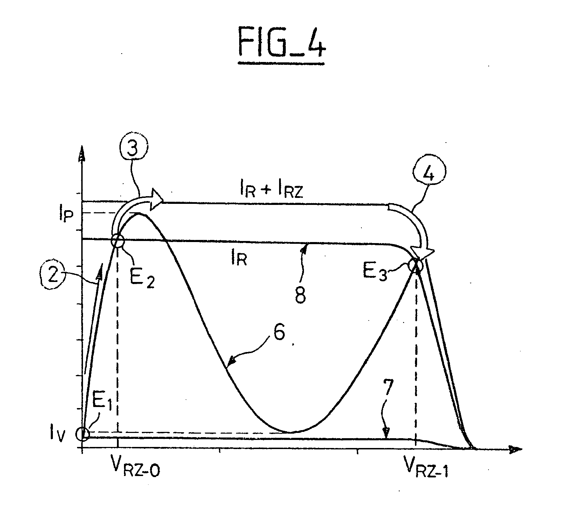

Le passage du courant I_{R} à un courant total I_{RZ} + I_{R} est représenté par la flèche ③ sur la figure 4. Ce courant total est supérieur au courant pic I_{P}.

Ainsi, afin d'être dans un nouvel état stable, la flèche ④ désigne le passage vers un nouvel état stable E₃ qui est le seul état stable possible. La tension aux bornes de la diode 2 qui est sensiblement égale à V_{OUT} est alors égale à V_{RZ-1} supérieure à la tension V_{RZ-0}.

Comme cet état E₃ est un état de fonctionnement stable, le dispositif 1 reste dans cet état même lorsque l'impulsion de lumière E a disparu.

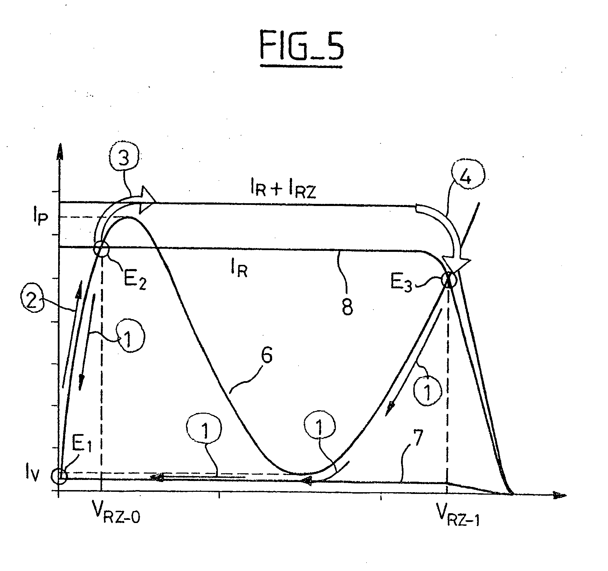

Lorsque le dispositif 1 est dans l'un des deux états stables E₂ ou E₃, une impulsion V_{RESET} permet de refaire passer le dispositif dans l'état E₁. Ce passage est représenté sur la figure 5 par les différentes flèches①.

La figure 6 représente les signaux V_{RESET}, I_{RZ}, I₁, I_{D} et Vₒᵤₜ en fonction du temps.

On voit clairement sur ces diagrammes que la tension V_{OUT} peut prendre trois valeurs V_{CC}, V_{RZ-0} et V_{RZ-1} correspondant respectivement aux états E₁, E₂ et E₃.

Cette tension V_{OUT} est l'image décalée dans le temps et améliorée de l'impulsion lumineuse E correspondant au courant I_{RZ}. En effet, si les impulsions du signal V_{RESET} sont suffisamment courtes, une impulsion de courant I_{RZ} correspondant à un « 1 » logique pourra donner naissance à une impulsion de tension V_{OUT} de durée supérieure à la durée de l'impulsion I_{RZ}. Plus l'impulsion I_{RZ} située entre deux impulsions V_{RESET} est rapprochée de la première impulsion V_{RESET} plus la durée de l'impulsion V_{OUT} sera grande ; c'est ce que l'on observe sur la troisième impulsion V_{OUT} représentée en figure 6.

Notons d'autre part que les demi-temps bit sont représentés par la durée séparant deux traits verticaux successifs. Il est alors clair que plus la durée d'impulsion de V_{RESET} sera petite devant un demi-temps bit, meilleure sera la marge de phase. En effet, plus la durée d'impulsion V_{RESET} est faible, plus l'impulsion de courant I_{RZ} a des chances de se produire entre deux impulsions V_{RESET}.

La source de courant commandée en tension comprenant la paire différentielle de transistors 3 et 4 tels que représentés en figure 1 est donnée à titre d'exemple et peut être remplacée par tout type de source de courant commandée en tension.

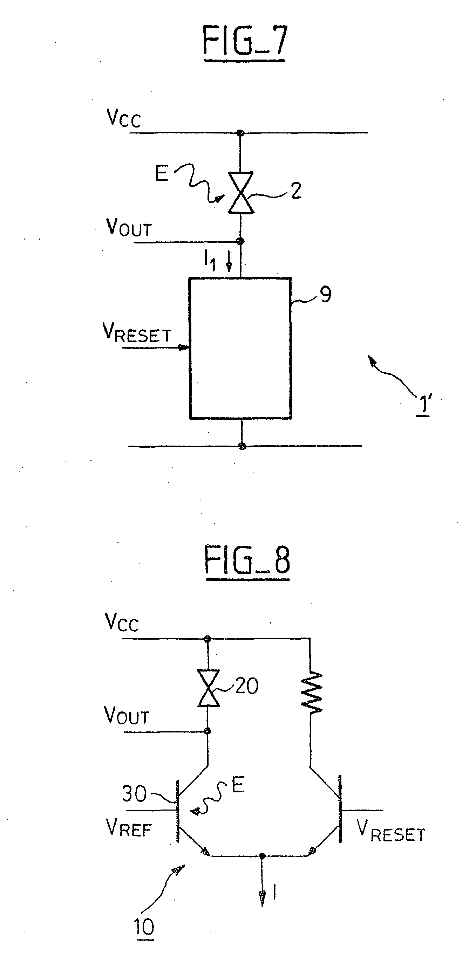

Ainsi, la figure 7 représente le principe de réalisation d'un dispositif 1' selon l'invention. Il est identique au dispositif tel que représenté en figure 1 à la différence près qu'il comporte une source quelconque de courant 9 commandée par la tension V_{RESET}.

La figure 8 représente un troisième mode de réalisation d'un dispositif 10 selon l'invention.

Le dispositif 10 est identique au dispositif tel que représenté en figure 1 à la différence près que la diode 20 est une diode à effet tunnel résonnant non photosensible et que le transistor bipolaire 30 est un transistor photosensible. Ces différences mises à part, le fonctionnement du dispositif 10 est similaire à celui décrit en référence aux figures 1 à 6.

Bien entendu, l'invention n'est pas limitée au mode de réalisation qui vient d'être décrit.

Notamment, on peut envisager d'utiliser un transistor bipolaire commandé directement par son courant de base sans utiliser de paire différentielle.

En outre, la description du dispositif a été faite en utilisant une diode à effet tunnel résonnant mais il est parfaitement envisageable d'utiliser une diode à effet tunnel classique.

Il est aussi possible de remplacer les transistors bipolaires tels que décrits par des transistors FET contrôlés par leurs tensions de grille.

## Revendications

1. Dispositif (1) de traitement d'un signal optique de données (E) d'entrée ayant un format de modulation de type RZ « retour à zéro », comportant un composant électronique (2) ayant une caractéristique de diode tunnel présentant un courant de pic (I_{P}) et un courant de vallée (I_{V}), ledit dispositif (1) étant **caractérisé en ce qu'**il comporte :
- une source de courant (3, 4, 9) commandée apte à injecter dans ledit composant électronique (2) un courant électrique fonction d'un signal de commande (V_{RESET}), ledit courant pouvant prendre une première valeur de courant ou une deuxième valeur de courant (I_{R}),
- des moyens générateurs (2, 30) de courant aptes à injecter dans ledit composant électronique (2) un courant électrique additionnel (I_{RZ}) généré en réponse audit signal de données d'entrée (E),
ledit courant de vallée (I_{V}) ayant une valeur supérieure strictement à ladite première valeur de courant et ledit courant de pic (I_{P}) ayant une valeur comprise entre ladite deuxième valeur de courant (I_{R}) et la somme de ladite deuxième valeur de courant (I_{R}) et de la valeur dudit courant généré (I_{RZ}) par lesdits moyens générateurs (2).

2. Dispositif (1) selon la revendication 1, **caractérisé en ce que** ledit composant électronique (2, 20) est une diode à effet tunnel résonnant.

3. Dispositif (1) selon la revendication 2, **caractérisé en ce que** ledit composant électronique (2) est une diode à effet tunnel résonnant photosensible qui constitue lesdits moyens générateurs de courant.

4. Dispositif (1) selon l'une des revendications 1 à 3, **caractérisé en ce que** ladite source de courant comporte deux transistors (3, 4) montés en paire différentielle alimentée par un courant fixé (I), l'un desdits transistors (3) étant monté en série avec ledit composant électronique (2).

5. Dispositif (10) selon l'une des revendications 1 ou 2, **caractérisé en ce que** ladite source de courant comporte deux transistors (3, 4) montés en paire différentielle alimentée par un courant fixé (I), l'un desdits transistors (30) étant un transistor photosensible monté en série avec ledit composant électronique (2), ledit transistor photosensible (30) constituant lesdits moyens générateurs de courant.

6. Dispositif (1) selon l'une des revendications 1 à 5, **caractérisé en ce que** ledit format de modulation du signal de données (E) d'entrée présentant un temps bit donné, ledit signal de commande (V_{REF}) est formé d'impulsions de tension de durée inférieure au demi temps bit.

7. Circuit de décision pour signal de données (E) d'entrée ayant un format de modulation de type RZ « retour à zéro » présentant un rythme d'horloge de fréquence donnée, **caractérisé en ce qu'**il comprend un dispositif de traitement selon l'une des revendications 1 à 6, et **en ce que** ledit signal de commande (V_{RESET}) est constitué d'un train d'impulsions ayant ladite fréquence donnée.

8. Circuit intégré comportant un dispositif selon l'une des revendications 1 à 6.

## Claims

1. A device (1) for processing an optical input data signal (E) having an RZ "return-to-zero" modulation format, comprising an electronic component (2) having a tunneling diode characteristic exhibiting a peak current (Iₚ) and a valley current (Iᵥ), said device (1) being **characterized in that** it comprises:
- a controlled source of current (3, 4, 9) capable of injecting into said electronic component (2) an electrical current depending on a control signal (V_{RESET}), said current being able to assume a first current value or a second current value (I_{R}),
- current-generating means (2, 30) capable of injecting into said electronic component (2) an additional electrical current (I_{RZ}) generated in response to said input data signal (E),
said valley current (I_{V}) having a value strictly greater than said first current value, and said peak value (I_{P}) having a value between said second current value (I_{R}) and the sum of said second current value (I_{R}) and the value of said current (I_{RZ}) generated by said generating means (2).

2. A device (1) according to claim 1, **characterized in that** said electronic component (2, 20) is a resonant tunneling diode.

3. A device (1) according to claim 2, **characterized in that** said electronic component (2) is a photosensitive resonant tunneling diode that constitutes said current-generating means.

4. A device (1) according to one of claims 1 to 3, **characterized in that** said source of current comprises two transistors (3, 4) mounted as a differential pair powered by a fixed current (I), one of said transistors (3) being mounted serially with said electronic component (2).

5. A device (10) according to claim 1 or 2, **characterized in that** said source of current comprises two transistors (3, 4) mounted as a differential pair powered by a fixed current (I), one of said transistors (30) being a photosensitive transistor mounted serially with said electronic component (2), said photosensitive transistor constituting said current-generating means.

6. A device (1) according to one of claims 1 to 5, **characterized in that** if said modulation format of the input data signal (E) exhibits a given bit time, said control signal (V_{REF}) is formed of voltage pulses whose duration is less than half the bit time.

7. A decision circuit for an input data signal (E) having an RZ "return to zero" modulation format exhibiting a clock speed of a given frequency, **characterized in that** it comprises a processing device according to one of claims 1 to 6, and **in that** said control signal (V_{RESET}) is constituted of a series of pulses having said given frequency.

8. An integrated circuit comprising a device according to one of claims 1 to 6.

## Patentansprüche

1. Vorrichtung (1) zur Verarbeitung eines optischen Eingangsdatensignals (E) mit einem Modulationsformat vom Typ RZ "Zurück zu Null", welche ein elektronisches Bauelement (2) mit einer einen Höckerstrom (Iₚ) und einen Talstrom (Iᵥ) aufweisenden Tunneldiodencharakteristik umfasst, wobei die besagte Vorrichtung (1) **dadurch gekennzeichnet ist, dass** sie umfasst:
- Eine gesteuerte Stromquelle (3, 4, 9), welche dazu ausgelegt ist, einen elektrischen Strom, welcher Funktion eines Steuersignals (V_{RESET}) ist, in das besagte elektronische Bauelement (2) einzuspeisen, wobei der besagte Strom einen ersten Stromwert oder einen zweiten Stromwert (I_{R}) annehmen kann,
- Stromerzeugungsmittel (2, 30), welche dazu ausgelegt sind, einen in Reaktion auf das besagte Eingangsdatensignal (E) erzeugten zusätzlichen elektrischen Strom (I_{RZ}) in das besagte elektronische Bauelement (2) einzuspeisen,
wobei der besagte Talstrom (I_{V}) einen Wert hat, welcher streng höher als der besagte erste Stromwert ist, und der besagte Höckerstrom (I_{P}) einen Wert hat, welcher zwischen dem besagten zweiten Stromwert (I_{R}) und der Summe des besagten zweiten Stromwerts (I_{R}) und des Wertes des besagten von den besagten Erzeugungsmitteln (2) erzeugten Stroms (I_{RZ}) liegt.

2. Vorrichtung (1) nach Anspruch 1, **dadurch gekennzeichnet, dass** das besagte elektronische Bauelement (2, 20) eine Diode mit Resonanz-Tunneleffekt ist.

3. Vorrichtung (1) nach Anspruch 2, **dadurch gekennzeichnet, dass** das besagte elektronische Bauelement (2) eine lichtempfindliche Diode mit Resonanz-Tunneleffekt ist, welche die besagten Stromerzeugungsmittel bildet.

4. Vorrichtung (1) nach einem der Ansprüche 1 bis 3, **dadurch gekennzeichnet, dass** die besagte Stromquelle zwei Transistoren (3, 4) aufweist, welche als von einem festgelegten Strom (I) versorgtes differentielles Paar angeordnet sind, wobei einer der besagten Transistoren (3) mit dem besagten elektronischen Bauelement (2) in Serie geschaltet ist.

5. Vorrichtung (10) nach einem der Ansprüche 1 oder 2, **dadurch gekennzeichnet, dass** die besagte Stromquelle zwei Transistoren (3, 4) aufweist, welche als von einem festgelegten Strom (I) versorgtes differentielles Paar angeordnet sind, wobei einer der besagten Transistoren (30) ein mit dem besagten elektronischen Bauelement (2) in Serie geschalteter lichtempfindlicher Transistor ist, wobei der besagte lichtempfindliche Transistor (30) die besagten Stromerzeugungsmittel bildet.

6. Vorrichtung (1) nach einem der Ansprüche 1 bis 5, **dadurch gekennzeichnet, dass** das besagte Modulationsformat des Eingangsdatensignals (E) eine gegebene Bitzeit aufweist, wobei das besagte Steuersignal (V_{REF}) aus Spannungsimpulsen, deren Dauer kürzer als die halbe Bitzeit ist, gebildet wird.

7. Entscheiderschaltung für ein Eingangsdatensignal (E) mit einem Modulationsformat vom Typ RZ "Zurück zu Null", welches eine Taktgeschwindigkeit mit einer gegebenen Frequenz aufweist, **dadurch gekennzeichnet, dass** sie eine Verarbeitungsvorrichtung nach einem der Ansprüche 1 bis 6 umfasst, und dass das besagte Steuersignal (V_{RESET}) aus einer Impulsfolge mit der besagten gegebenen Frequenz besteht.

8. Integrierter Schaltkreis mit einer Vorrichtung nach einem der Ansprüche 1 bis 6.
